# EUROPEAN PATENT SPECIFICATION

(11) **EP 1 916 726 B1**
(45) Date of publication and mention of the grant of the patent: **20.07.2016**
(21) Application number: 07119429.4
(22) Date of filing: 26.10.2007
(51) Int. Cl.: H01L 51/56

(54) **Mask and deposition apparatus using the same**
Maske und Auftragungsvorrichtung damit
Masque et appareil de dépôt l'utilisant

(30) Priority: 27.10.2006 KR 20060105109
(43) Date of publication of application: 30.04.2008
(73) Proprietor: Samsung Display Co., Ltd., Gyeonggi-do (KR)
(72) Inventor: Kim, Tae-Seung, Gyeonggi-do (KR)
(74) Representative: Gulde & Partner

(56) References cited:
- EP-A- 0 219 873
- EP-A- 1 426 461
- WO-A1-2006/027830
- DE-A1-102005 005 937
- GB-A- 2 401 711
- JP-A- 9 143 697
- JP-A- 2003 293 122
- US-A1- 2002 059 903
- US-A1- 2003 150 384
- US-A1- 2003 228 417
- US-A1- 2004 031 442
- US-B1- 6 255 775
- SHTEIN MAX ET AL: "Micropatterning of small molecular weight organic semiconductor thin films using organic vapor phase deposition" JOURNAL OF APPLIED PHYSICS, AMERICAN INSTITUTE OF PHYSICS. NEW YORK, US, vol. 93, no. 7, 1 April 2003 (2003-04-01), pages 4005-4016, XP012059341 ISSN: 0021-8979

## Description

### CROSS-REFERENCE TO RELATED APPLICATIONS

This application claims the benefit of Korean Patent Application No. 2006-0105109, filed on October 27, 2006, in the Korean Intellectual Property Office.

### BACKGROUND

### 1. Field

The present invention relates to a mask.

### 2. Description of the Related Technology

Generally, an organic light emitting diode used for a flat panel display device includes two electrodes opposing each other. The diode also includes an organic layer interposed between the two electrodes. The organic layer includes an emission layer, and optionally at least one of a hole injection layer, a hole transport layer, an electron transport layer, and an electron injection layer, etc. These layers are thin films made of organic materials. In manufacturing an organic light emitting diode, organic thin films such as an emission layer, a hole injection layer, a hole transport layer, an electron transport layer, or an electron injection layer, etc. may be formed by a deposition method using a deposition apparatus.

A mask showing the features of the preamble of claim 1 is known from WO2006/027830.

### SUMMARY OF CERTAIN INVENTIVE ASPECTS

Claim 1 is directed to a mask for use in depositing a thin film on a partially fabricated display device. The mask comprises a first region including an array of first openings, each of the first openings having a first length measured along a first axis, the first region having an edge extending along a second axis substantially perpendicular to the first axis; and a second region adjoining the edge of the first region, the second region including an array of second openings, each of the second openings having a second length measured along the first axis, the second length being at least twice the length of the first length, wherein the second openings are substantially aligned with the first openings along the first axis.

The second length is a multiple integer of the first length. Each of the first openings may have a substantially square shape. Each of the second openings may have a stripe shape extending along the first axis. The first openings may be arranged in a matrix form. Each of the first openings may have a first width measured along the second axis, and each of the second openings may have a second width measured along the second axis. The first width may be substantially the same as the second width. The second openings may be substantially aligned with one another along the second axis.

Each of the first openings may have a first size, and each of the second openings may have a second size. The second size may be at least twice as large as the first size. The ratio of the areas of the first region and the second region may be about 4:3.

A deposition apparatus for forming a thin film on a partially fabricated display device comprises a chamber; a substrate supporter positioned within the chamber; at least two deposition sources facing the substrate supporter, the deposition sources being spaced apart from one another, the deposition sources being configured to vaporize a deposition material toward the substrate supporter; and the mask described above, the mask being positioned between the substrate holder and the deposition sources, wherein the deposition sources are substantially aligned with one another along the first axis.

The deposition sources may be provided with a moving device installed in the chamber, for moving the deposition sources horizontally or vertically. The number of deposition sources may vary with the size of the substrate. Preferably, the deposition sourced are configured to provide a simultaneous material deposition on the entire surface of the substrate.

A method of making a display device comprises: placing a partially fabricated display device in the deposition apparatus described above, such that the display device is supported by the substrate holder while being interposed between the substrate holder and the mask, the display device having a surface facing the mask; and vaporizing a deposition material from the deposition sources such that the deposition material passes through the mask, thereby selectively reaching portions of the surface of the display device. Preferably, the substrate, the deposition sources and the mask are maintained in a fixed position to each other while the deposition material is vaporized from the deposition sources onto the substrate through the mask. Furthermore, preferably each of the deposition sources is arranged at a predetermined distance from a first axis which extends perpendicular to the substrate through a center point (or centroid) of the substrate. More preferably, the distance between the deposition material outlet of each of the deposition sources and said first axis amounts to at least 10% of the lateral extension (of the longer edge) of the substrate.

The display device may be an organic light emitting display device. The deposition material may be an organic light-emitting material.

An organic light emitting display device commonly comprises: a substrate having a pixel region, the pixel region having a first region and a second region adjoining the first region in a first direction; an array of first organic layers formed over the first region of the substrate, each of the first organic layers having a first length measured along a first axis extending in the first direction; and an array of second organic layers formed over the second region of the substrate, each of the second organic layers having a second length measured along the first axis, the second length being at least twice the length of the first length, wherein the second organic layers are substantially aligned with the first organic layers along the first axis.

The mask is further to deposit a thin film on a substrate including a plurality of sub-pixel regions and positioned on front of the substrate. The mask comprises a first region having a plurality of the first openings which corresponds to each region of a plurality of the sub-pixel regions, and a second region having a plurality of the second openings which corresponds to at least two sub-pixel regions of a plurality of the sub-pixel regions and positioned on the both sides of the first region having a plurality of the first openings.

### BRIEF DESCRIPTION OF THE DRAWINGS

Fig. 1 is a perspective view illustrating a conventional deposition apparatus for forming a thin film on a substrate.
Fig. 2 illustrates a conventional mask used for depositing a thin film.
Fig. 3 is a micrograph, taken with a scanning electron microscope, of a thin film pattern formed on a substrate, using a conventional mask.
Fig. 4 is an exploded perspective view of a mask according to one embodiment.
Fig. 5 is a cross-sectional view illustrating a deposition apparatus for forming a thin film on a substrate
Fig. 6 is a perspective view of an organic light emitting display device
Fig. 7 is a cross-sectional of the device of Fig. 6, taken along the line I-I' in Fig. 6.
Fig. 8 is a cross-sectional view of the device of Fig. 6, taken along the line II-II' in Fig. 6.
Fig. 9 is a cross-sectional view of the device of Fig. 6, taken along line III-III' in Fig. 6.

### DETAILED DESCRIPTION OF CERTAIN INVENTIVE EMBODIMENTS

In making a device having a large size substrate, a multiple deposition method to deposit a thin film using a plurality of deposition sources can be used to form an organic material layer. Such a method provides fine step coverage and uniformity on a substrate.

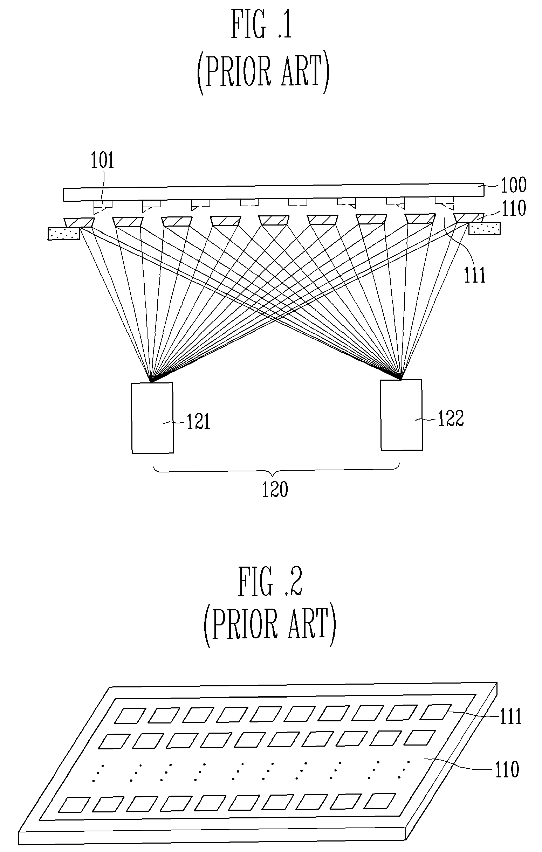

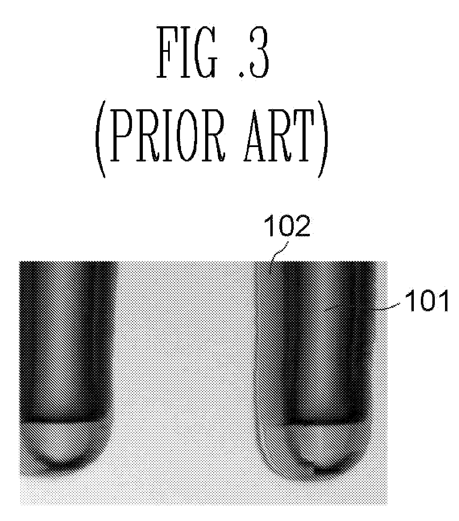

Fig. 1 illustrates a conventional mask used for forming a thin film on a substrate. Fig. 2 is a perspective view illustrating a conventional deposition apparatus for forming a thin film on a substrate. Fig. 3 is a micrograph illustrating a thin film pattern formed on a substrate using the conventional mask.

Referring to Figs. 1 to 3, a chamber (not shown) includes a substrate 100 on which a thin film 101 is to be formed, a mask 110 positioned in front of the substrate 100, and at least two deposition sources 120 to provide material for the thin film 101.

In order to form the thin film 101 on the substrate 100, deposition materials are vaporized by heating deposition sources containing deposition materials. The deposition materials evaporated from deposition sources 120 are deposited on the substrate 100 through openings 111 of the mask 110. The openings 111 may be dot-shaped. Thin film patterns 101 corresponding to the dot shaped openings 111 are formed on the substrate 100.

However, portions of the materials which are directed to peripheries of the substrate 100 may not sufficiently reach the substrate 100, which may cause a non-uniform thickness at the peripheries of the substrate. Such portions have a small incident angle to the mask 110. Thus, the portions, while traveling toward the substrate 100, may be blocked by the mask 110, and may not reach the substrate 100 in a sufficient amount to form a layer of a uniform thickness. Thus, the peripheries of the substrate 100 may have sawtooth-shaped layers, as shown in Fig. 1.

As shown in Fig. 3, a thin film pattern corresponding to the shape of the openings 111 may not be formed on the substrate 100. The thin film 101 may not be uniform. In Fig. 3, a portion 102 of the film 101 is thinner than another portion 101 thereof. These problems occur since the deposition materials are properly deposited on some regions, but not on other regions as described above.

A method forming a thin film on a substrate using a mask including stripe-shaped openings is proposed to provide a thin film having a uniform thickness. However, the mask including the stripe-shaped openings tends to bend down in its middle region due to external tensile force and its own weight. Therefore, a uniform thin film cannot be formed on a substrate, causing a so-called shadow phenomenon, for example, at the portion 102 of Fig. 3.

In one embodiment of the present invention, a mask has a central region and two edge regions. The mask includes a plurality of first openings in the central region and a plurality of second openings in the edge regions. The second openings have a size at least twice as large as the first openings.

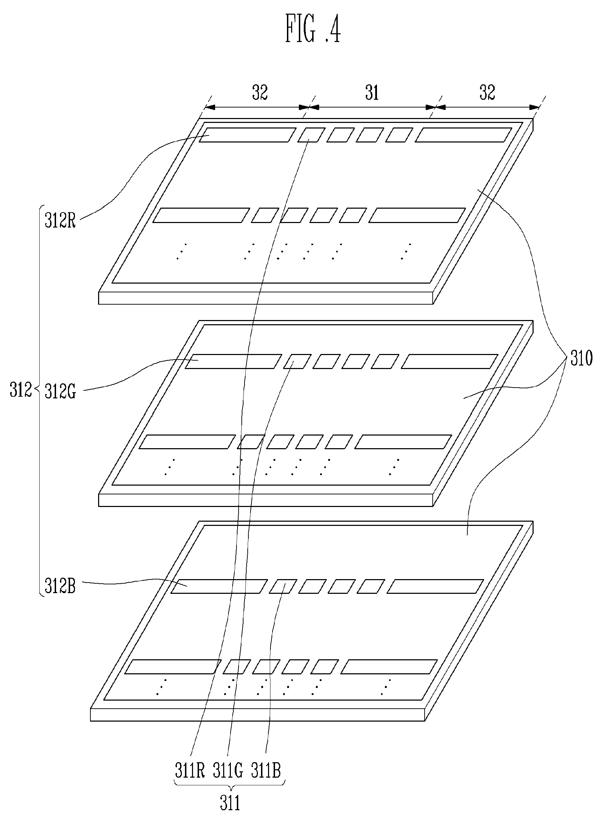

Fig. 4 is an exploded perspective view illustrating a mask used for depositing a thin film on a substrate, according to claim 1. An organic light emitting display device may be made using the mask. A substrate (not shown) on which a thin film is to be formed is first provided. The substrate may include a plurality of sub-pixel regions. A mask 310 may be positioned to face a surface of the substrate. The illustrated mask 310 includes a first region 31 and two second regions 32. The first region 31 includes a plurality of first openings 311, each corresponding to one of the plurality of sub-pixel regions. The second regions 32 include a plurality of second openings 312, each corresponding to at least two of the plurality of sub-pixel regions. The second regions 32 are positioned on both sides of the first region 31.

In the illustrated embodiment, the first region 31 includes a plurality of dot-shaped (i.e. having the same vertical and horizontal dimensions, e.g. circular or square-shaped) first openings in a matrix form. The plurality of dot-shaped first openings 311 correspond to sub-pixel regions (sub-pixel: R, G, B) in the emission region of the substrate.

The sub-pixel regions described in the embodiment are defined by a pixel definition film formed over the substrate. The pixel definition layer has a plurality of openings. Each opening defines one of the sub-pixel regions.

In the illustrated mask, a plurality of first red openings 311R are arranged to correspond to red sub-pixel regions to be formed on the substrate. A plurality of first green openings 311 G are arranged to correspond to green sub-pixel regions to be formed on the substrate. A plurality of first blue openings 311B are arranged to correspond to blue sub-pixel regions to be formed on the substrate.

In addition, the second openings 312 are formed on the second regions 32 on both sides of the first region 31. The second openings 312 are aligned with the first openings 311. The second openings 312 have a stripe shape. The second openings 312 have a size at least twice as large as that of a sub-pixel region on the substrate. The second openings 312 may have red, green, and blue openings 312R, 312G, 312B. Each of the second red openings 312R may have a size at least twice as large as that of a red sub-pixel region on the substrate. Each of the second green openings 312G may have a size at least twice as large as that of a green sub-pixel region on the substrate. Each of the second blue openings 312B may have a size at least twice as large as that of a blue sub-pixel region on the substrate.

The first openings 311 and the second openings 312 may be formed by an etching method using, for example, photolithography, an electroforming method using photolithography and electrolysis, and a laser cutting method. In one embodiment, the ratio of the areas of the first region 31 and the second region 32 is about 4:3.

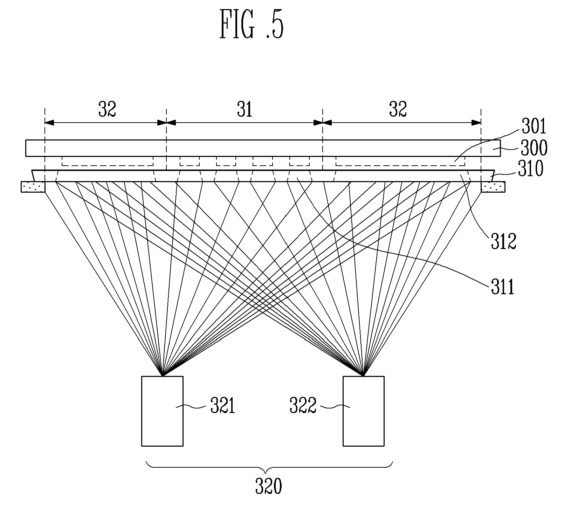

Fig. 5 is a cross-sectional view illustrating a deposition apparatus for forming a thin film on a substrate.

Referring to Fig. 5, the deposition apparatus includes a chamber (not shown), a supporter (not shown) for supporting or holding a substrate 300, at least two deposition sources 320 for supplying deposition materials on the substrate 300, and a mask 310.

The deposition sources 320 are positioned at the lower side of the chamber. The deposition sources include deposition materials and a heater. The heater is configured to vaporize the deposition materials such that the materials can be deposited on the substrate 300. The deposition source 320 can move horizontally or vertically, using a moving device (not shown) installed in the chamber. The illustrated deposition sources 320 include a first deposition source 321 and a second deposition source 322. This configuration can simultaneously provide the deposition materials on substantially the entire surface of the substrate 300. It will be appreciated that various numbers of deposition sources can be used, depending on the size of the substrate.

The substrate supporter is configured to support the substrate 300. The supporter is provided at the upper side of the chamber. The supporter opposes the deposition source provided at the lower side of the chamber.

The mask 310 includes a first region 31 having a plurality of the first openings 311, and two second regions 32 having a plurality of second openings 312. The first region 31 is interposed between the two second regions 32. In one embodiment, the first region 31 and one of the second regions 32 have an area ratio of about 4:3. The second openings 312 may have a size at least twice as large as that of the first openings 311. The first openings 311 and the second openings 312 together determine a pattern of a thin film which will be formed on the substrate 300. The mask 310 is positioned between the substrate 300 and the deposition sources 320. The mask 310 can be fixed on the substrate 300 by welding or by an adhesive.

The first openings 311 are dot-shaped and arranged in a matrix form. Each of the openings 311 has a size corresponding to that of one of sub-pixel regions (sub-pixel: R, G, B) of the substrate 300. For example, the mask 310 may have first openings 311 corresponding to a plurality of red sub-pixel regions of the substrate 300. For example, a plurality of red thin films 301 corresponding to the red sub-pixel regions (R) can be formed on the substrate 300.

The second openings 312 are provided on both edges of the first region 31. The second openings 312 may have a stripe shape. The stripe-shaped second openings 312 may a size at least twice as large as a sub-pixel region (e.g., sub-pixel: R). Accordingly, continuous thin films 301 having a size corresponding to two red sub-pixel regions (R, R) can be formed on the substrate 300.

In the illustrated embodiment, the large-sized second openings 312 are formed in the second regions 32, opening the peripheries of the substrate. Therefore, even if the depositing angle of the deposition material evaporated from the first deposition source 321 or the second deposition source 322 is small, it is possible to prevent interference due to the mask pattern. The configuration of the mask 310 can provide high resolution display devices since a thin film can be formed on a substrate without a shadow phenomenon.

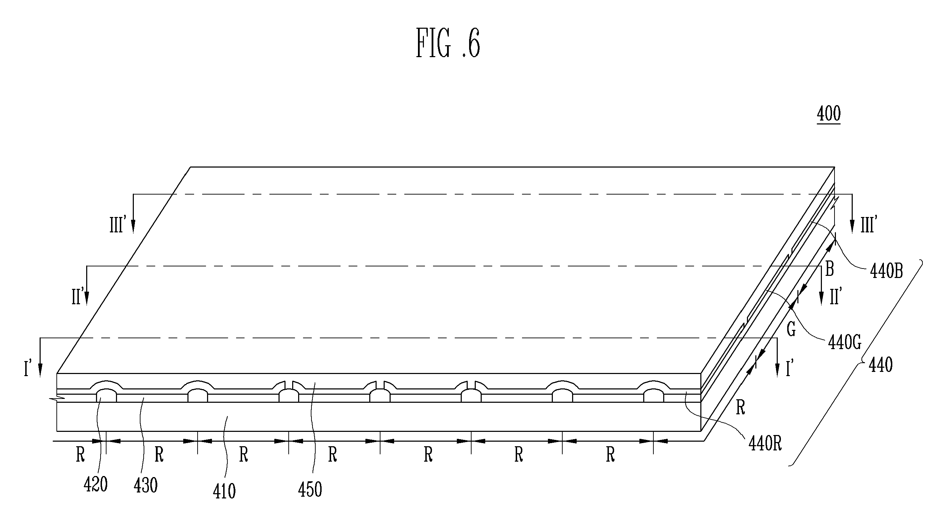

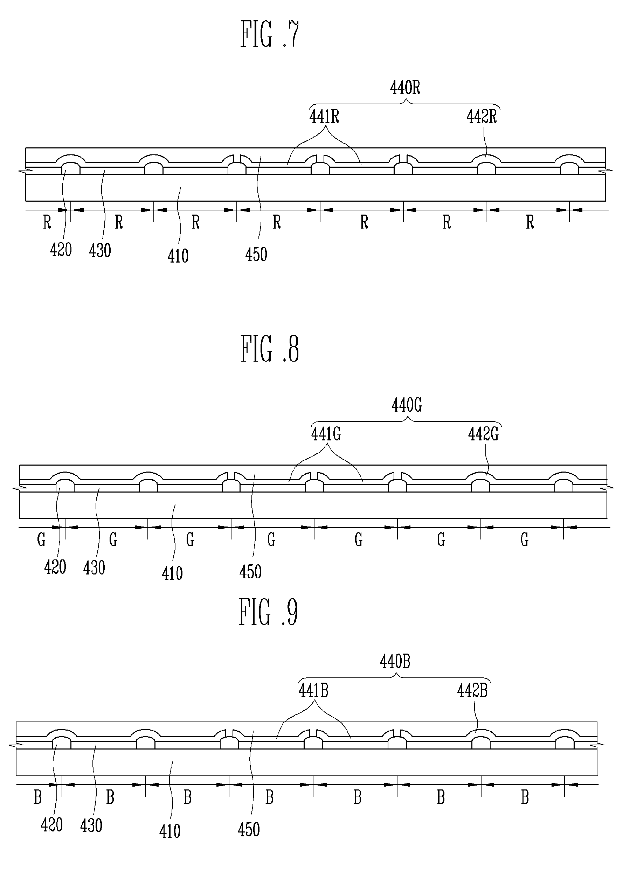

Fig. 6 is a perspective view of an organic light emitting display device. Fig. 7 is a cross-sectional view of the display device, taken along the line I-I' in Fig. 6. Fig. 8 is a cross-sectional view of the display device, taken along the line II-II' in Fig. 6. Fig. 9 is a cross-sectional view of the display device, taken along the line III-III' in Fig. 6.

Referring to Fig. 6 to Fig. 9, an organic light emitting display device 400 has a plurality of sub-pixels formed over a substrate 410. Each sub-pixel includes a first electrode layer, a second electrode layer 430, 450 and an emission layer 440 interposed between the first electrode layer and the second electrode layer 430, 450. Referring to Fig. 7, the display device 400 includes a plurality of first patterns 441 of a first size and a plurality of second patterns 442 of a second size. Each of the first patterns 441 forms one of sub-pixels of the display device. The second patterns 442 may have a size at least twice as large as that of a sub-pixel. The second patterns 442 are positioned on both sides of the first patterns 441. A plurality of red, green and blue sub-pixels (R sub-pixel, G sub-pixel, B sub-pixel) formed of an emission layer 440 are positioned between the first electrode layer and the second electrode layer 430, 450.

The first electrode layer 430 may be formed on the substrate by depositing and patterning a conductive layer. The first electrode layer may be either a transparent electrode or a reflective electrode. The transparent electrode can be formed of ITO, IZO, ZnO, or In₂O₃. The reflective electrode can be formed of Ag, Mg, Al, Pt, Pd, Au, Ni, Nd, Ir, Cr, or a combination thereof. The reflective electrode may further include a layer formed of ITO, IZn, ZnO, or In₂O₃. A pixel definition film 420 is formed on the first electrode layer 430. The pixel definition film 420 has openings at least partially exposing the first electrode layer.

A red emission layer 440R may have first red patterns 441R and second red patterns 442R in red sub-pixel regions (R). A green emission layer 440G may have first green patterns 441G and second green patterns 442G in green sub-pixel regions (G).

The red emission layer 440R may have a plurality of first red patterns 441R which form red sub-pixels. The second red patterns 442R are arranged on both sides of the first red pattern 441R. The second red patterns 442R may have a size at least twice as large as that of a red sub-pixel regions (R). Similarly, the green and blue emission layers 440G, 440B may have green and blue patterns 441G, 441B, 442G, 442B, which form green and blue sub-pixels, respectively.

The second electrode layer 450 is formed on the red, green and blue emission layers 440R, 440G, 440B. The second electrode layer 450 can be either a transparent electrode or a reflective electrode. The transparent electrode can be formed by first depositing a low work function metal such as Li, Ca, LiF/Ca, LiF/Al, Al, Ag, Mg or a combination thereof on the emission layer 440, and then forming another layer with ITO, IZO, ZnO or In₂O₃ on the metal. The reflective electrode can be formed of Li, Ca, LiF/Ca, LiF/Al, Al, Ag, Mg or a combination thereof.

The masks described above can provide uniform thin films on a substrate. Further, the uniform the thin films can provide a display device which is capable of displaying high quality pictures with a high resolution.

## Claims

1. A mask (310) for use in depositing a thin film (301) on a partially fabricated display device including a plurality of sub-pixel regions, the mask (310) comprising:
a first region (31) including an array of first openings (311) which correspond to each region of a plurality of the sub-pixel regions, each of the first openings (311) having a first length measured along a first axis and being adapted to deposit one of the plurality of sub-pixel regions, the first region (31) having an edge extending along a second axis perpendicular to the first axis; and
a second region (32) adjoining the edge of the first region (31), the second region (32) including an array of second openings (312) which correspond to at least two sub-pixel regions of a plurality of the sub-pixel regions and which are positioned on both edges of the first region having a plurality of the first openings, each of the second openings (312) having a second length measured along the first axis,
wherein each of the first openings (311) has a first width measured along the second axis, each of the second openings (312) has a second width measured along the second axis, and the first width is the same as the second width; wherein the second openings (312) are aligned with the first openings (311) along the first axis
**characterized in**
**that** each of the second openings (312) having the second length being at least twice the length of the first length and is adapted to deposit at least two of the plurality of sub-pixel regions.

2. The mask of claim 1, wherein each of the first openings (311) has a square shape.

3. The mask of one of the preceding claims, wherein each of the second openings (312) has a stripe shape extending along the first axis.

4. The mask of one of the preceding claims, wherein the first openings (311) are arranged in a matrix form.

5. The mask of one of the preceding claims, wherein the second openings (312) are disposed parallel to one another along the second axis.

6. The mask of one of the preceding claims, wherein the ratio of the areas of the first region (31) and the second region (32) is about 4:3.

## Patentansprüche

1. Maske (310) zur Verwendung beim Ablagern eines Dünnfilms (310) auf einer teilweise hergestellten Anzeigevorrichtung, aufweisend eine Vielzahl von Subpixelbereichen, wobei die Maske (310) aufweist:
einen ersten Bereich (31), der eine Anordnung erster Öffnungen (311), die mit jedem Bereich einer Vielzahl der Subpixelbereiche korrespondieren, aufweist, wobei jede der ersten Öffnungen (311) eine erste Länge, die entlang einer ersten Achse gemessen wird und angepasst ist, um einen der Vielzahl der Subpixelbereiche abzulagern, aufweist, wobei der erste Bereich (31) einen Rand, der sich entlang einer zweiten Achse, die perpendikulär zur ersten Achse ist, erstreckt, aufweist; und
einen zweiten Bereich (32), der an den Rand des ersten Bereichs (31) angrenzt, wobei der zweite Bereich (32) eine Anordnung zweiter Öffnungen (312), die mit zumindest zwei Subpixelbereichen einer Vielzahl der Subpixelbereiche korrespondieren und die auf beiden Rändern des ersten Bereichs, der eine Vielzahl der ersten Öffnungen aufweist, positioniert sind, aufweist, wobei jede der zweiten Öffnungen (312) eine zweite Länge, die entlang der ersten Achse gemessen wird, aufweist,
wobei jede der ersten Öffnungen (311) eine erste Breite, die entlang der zweiten Achse gemessen wird, aufweist, wobei jede der zweiten Öffnungen (312) eine zweite Breite, die entlang der zweiten Achse gemessen wird, aufweist, und wobei die erste Breite gleich der zweiten Breite ist; wobei die zweiten Öffnungen (312) entlang der ersten Achse mit den ersten Öffnungen (311) fluchten,
**dadurch gekennzeichnet,**
**dass** jede der zweiten Öffnungen (312) die zweite Länge, die mindestens zweimal die Länge der ersten Länge ist, aufweist und angepasst ist, um zumindest zwei der Vielzahl der Subpixelbereiche abzulagern.

2. Maske nach Anspruch 1, wobei jede der ersten Öffnungen (311) eine quadratische Form aufweist.

3. Maske nach einem der vorhergehenden Ansprüche, wobei jede der zweiten Öffnungen (312) eine Streifenform, die sich entlang der ersten Achse erstreckt, aufweist.

4. Maske nach einem der vorhergehenden Ansprüche, wobei die ersten Öffnungen (311) in einer Matrixform angeordnet sind.

5. Maske nach einem der vorhergehenden Ansprüche, wobei die zweiten Öffnungen (312) parallel zueinander entlang der zweiten Achse angeordnet sind.

6. Maske nach einem der vorhergehenden Ansprüche, wobei das Verhältnis der Flächen des ersten Bereichs (31) und des zweiten Bereichs (32) etwa 4:3 ist.

## Revendications

1. Masque (310) destiné à être utilisé dans le dépôt d'un film mince (301) sur un dispositif d'affichage partiellement fabriqué comportant une pluralité de zones de sous-pixels, le masque (310), comprenant :
une première zone (31) comportant un réseau de premières ouvertures (311) qui correspondent à chaque zone d'une pluralité des zones de sous-pixels, chacune des premières ouvertures (311) ayant une première longueur mesurée le long d'un premier axe et étant adaptée pour le dépôt sur une zone de la pluralité de zones de sous-pixels, la première zone (31) ayant un bord s'étendant le long d'un deuxième axe perpendiculaire au premier axe ; et
une deuxième zone (32) contiguë au bord de la première zone (31), la deuxième zone (32) comportant un réseau de deuxièmes ouvertures (312) qui correspondent à au moins deux zones de sous-pixels d'une pluralité de zones de sous-pixels et qui sont positionnées sur les deux bords de la première zone ayant une pluralité des premières ouvertures, chacune des deuxièmes ouvertures (312) ayant une deuxième longueur mesurée le long du premier axe,
dans lequel chacune des premières ouvertures (311) a une première largeur mesurée le long du deuxième axe, chacune des deuxièmes ouvertures (312) présente une deuxième largeur mesurée le long du deuxième axe, et la première largeur est la même que la deuxième largeur ; dans lequel les deuxième ouvertures (312) sont alignées avec les premières ouvertures (311) le long du premier axe,
**caractérisé en ce que**
chacune des deuxièmes ouvertures (312) ayant la deuxième longueur étant au moins deux fois la longueur de la première longueur et est adaptée pour déposer au moins deux zones de la pluralité de zones de sous-pixels.

2. Masque de la revendication 1, dans lequel chacune des premières ouvertures (311) a une forme carrée.

3. Masque de l'une des revendications précédentes, dans lequel chacune des deuxièmes ouvertures (312) a une forme de bande s'étendant le long du premier axe.

4. Masque de l'une des revendications précédentes, dans lequel les premières ouvertures (311) sont agencées sous une forme matricielle.

5. Masque de l'une des revendications précédentes, dans lequel les deuxièmes ouvertures (312) sont disposées parallèlement les unes aux autres le long du deuxième axe.

6. Masque de l'une des revendications précédentes, dans lequel le rapport des superficies de la première zone (31) et de la deuxième zone (32) est d'environ 4:3.
